# EUROPEAN PATENT SPECIFICATION

(11) **EP 4 421 022 B1**
(45) Date of publication and mention of the grant of the patent: **02.09.2026**
(21) Application number: 23158813.8
(22) Date of filing: 27.02.2023
(51) Int. Cl.: B81B 7/00

(54) **DOUBLE LAYER MEMS DEVICES**
DOPPELSCHICHTIGE MEMS-VORRICHTUNGEN
DISPOSITIFS MEMS À DOUBLE COUCHE

(43) Date of publication of application: 28.08.2024
(73) Proprietor: Murata Manufacturing Co., Ltd., Nagaokakyo-shi, Kyoto 617-8555 (JP)
(72) Inventor: TORKKELI, Altti, Tuusula (FI); FUKUMITSU, Mazakasu, Kyoto (JP); BLOMQVIST, Anssi, Helsinki (FI); MATTI, Liukku, Helsinki (FI); RYTKÖNEN, Ville-Pekka, Klaukkala (FI); OKAWA, Tadayuki, Kyoto (JP); KILPINEN, Petteri, Espoo (FI)
(74) Representative: Boco IP Oy Ab

(56) References cited:
- US-A1- 2008 290 430
- US-A1- 2016 090 297

## Description

### Field

The present invention relates to MEMS devices and a method of producing MEMS devices. More particularly, the present invention relates to MEMS devices comprising two device layers and to methods for manufacturing double layer MEMS devices.

### Background

Microelectromechanical systems (MEMS) devices manufactured using silicon-based technology are widespread. Typical application of MEMS device is an inertial sensor that detects at least one of acceleration and angular velocity. MEMS devices of this type are widely used in consumer, automotive and industrial applications.

Capacitive sensing in MEMS devices is implemented by detecting change of capacitance caused by change in distance between two electrodes. Typically, capacitance is sensed between a moveable electrode and one or more static electrodes.

In typical capacitive MEMS devices for inertial sensing, static electrodes are provided on a substrate, such as a handle or a cap wafer. For example, a metal electrode may be provided on a surface of the substrate wafer. The MEMS device is subject to various sources of stress. During packaging of components, some steps of the process such as molding applies pressure on the substrate. Different materials have different thermal characteristics and therefore the substrate may also be subject to pressure due to differences in thermal expansion of materials within the MEMS device package. The MEMS device may also be subject to various external forces causing changes in the shape of the substrate. Environment in which the MEMS device is used may be subject to great temperature changes, vibration, impacts and so on, all causing stress on the MEMS device. When static electrodes are attached to the substrate, any change in form of the substrate caused by stress may also affect distance between the static electrodes and respective moveable electrodes. This causes risk of deterioration of accuracy of capacitive sensing.

In the following description, reference will be made to an inertial MEMS sensor and to the problems for the manufacturing thereof. However, the present disclosure generally applies to other types of MEMS devices. For example, the MEMS device may comprise one or more of the following structures, single or combined with each other: accelerometer, gyroscope, geophone, inclinometer and resonator. Furthermore, the MEMS device may be a MEMS actuator.

### Description of the related art

Patent application US20200156930 discloses a double side capacitive sensing MEMS device having a hollow body. This device is manufactured by epitaxial growing of a polysilicon (poly-Si) structure. Basic principle of manufacturing a silicon-on-insulator (SOI) structure is to use insulator, such as silicone dioxide, as a sacrificial layer in isotropic etching steps. A gap between two overlapping layers is implemented by isotropic etching holes provided in a polysilicon layer. However, perforation of the poly-Si mass reduces seismic mass and capacitance and thus reduces sensitivity of the sensor device.

Patent application US20210363000A1 discloses a MEMS device and a process for manufacturing a MEMS device that applies growth of a thick epitaxial polysilicon to determine two structural layers.

Patent application US20160090297A1 discloses a SOI MEMS devices with MEMS platform separated from the rest of a substrate layer by stress-relief gaps and a process for manufacturing such devices.

### Summary

An object is to provide a method and apparatus so as to solve the problem of improving accuracy of a MEMS device in case of stress affecting the MEMS device. The objects of the present invention are achieved with a MEMS device according to the claim 1. The objects of the present invention are further achieved with a method according to the claim 10.

The preferred embodiments of the invention are disclosed in the dependent claims.

The present invention is based on the idea of having two suspended device layers in the MEMS device: a first device layer comprises suspended, non-moving structural elements and a second device layer comprises suspended seismic, moveable masses. Structural elements in the first device layer are suspended to a handle layer and/or via the second device layer to a cap layer by rigid suspension structures, such as anchors. The first device layer comprises structures used as static electrodes and the first device layer may also be used for electrical routing. The second device layer comprises seismic masses used as moveable electrodes and/or seismic masses coupled to moveable electrodes. As known in the art, suspension of seismic masses typically comprises flexible suspension structures such as springs and beams that are designed to enable one or more wanted movement directions of the seismic mass but to suppress any unwanted movement directions of the seismic mass. Both device layers are made of monocrystalline silicon (mono-Si), manufactured using a silicon-on-insulator, SOI, process that utilizes etching, preferably dry etching such as deep reactive-ion etching (DRIE) or like, for determining functional elements in the device layers.

The present invention has the advantage that the two device-layer structure improves accuracy of the MEMS device by providing mechanically stable structures within the MEMS device that are robust against stress deformation, while the invented device structure also facilitates high design flexibility and small die area. Because both moving and static electrodes can be implemented as mechanically separated from the substrate (the handle layer and the cap layer), stress affecting the substrate does not cause changes in geometry of the structural elements in the device layers. Sensitivity to stress can further be improved by suspending both device layers on laterally common anchor locations. Some embodiments of the double silicon device layered design can be designed and manufactured without need for perforation of functional elements in the device layers, thus avoiding reduction of capacitance and mass caused by such perforation, which facilitates higher capacitance and improved sensitivity of the MEMS device.

### Brief description of the drawings

In the following the invention will be described in greater detail, in connection with preferred embodiments, with reference to the attached drawings, in which
Figure 1 illustrates a cross-section of a MEMS device according to a first embodiment.
Figure 2 illustrates a cross-section of a MEMS device according to a second embodiment.
Figure 3 illustrates a signal path in a MEMS device.
Figures 4a to 4l illustrate a manufacturing process of a MEMS device according to a third embodiment.
Figures 5a to 5j illustrate a manufacturing process of a MEMS device according to the second embodiment.
Figure 6 illustrates mains steps of a manufacturing process.
Figure 7 illustrates a cross-section of a MEMS device with bumps on the cap layer.
Figure 8 illustrates a cross-section of a MEMS device with poly-Si bumps in the first device layer.
Figures 9a to 9f illustrate a process for manufacturing poly-Si feedthroughs and bumps.
Figure 10 illustrates a cross-section of a variation of the MEMS device according to the first embodiment.
Figure 11 illustrates a cross-section of a variation of the MEMS device according to the third embodiment.
Figure 12 illustrates a further variation of a MEMS device according to some embodiments.

Cross-section figures are not in scale.

### Detailed description

Single-crystal silicon, mono-Si, known also as monocrystalline silicon is the well-known base semiconductor material for silicon-based discrete components and integrated circuits. It consists of silicon in which the crystal lattice of the entire solid is continuous. Mono-Si is the material of first choice for robust MEMS devices, because of its excellent mechanical strength and elasticity, and the large variety of available standard processes. It is well known in the art, that in MEMS devices, mono-Si layer is used as a conductor, for which purpose it is doped to make it electrically conducting. For example, Boron-doped P-type silicon wafers are common, but also Phosphorus (P) doped N-type wafers are used in some special applications.

In this context, polysilicon, poly-Si, known also as polycrystalline silicon or multicrystalline silicon refers to silicon consisting of small crystals, known as crystallites. Like mono-Si, also polysilicon is doped to make it electrically conducting.

In this context, silicone dioxide, known also as silica, is an oxide of silicon with chemical formula SiO₂. Silicon dioxide is an electrical insulator.

In the following description, direction up refers to direction of the positive z-axis and direction down is direction of negative z-axis for convenience. It is to be understood, that these directions are not to be understood as limiting the position of use of the MEMS device. The simplified MEMS device has only a limited number of structural elements, such as anchors, beams, electrical contacts, masses and/or limiters, often just one of each. It is understood by a skilled person that an actual MEMS device may comprise more than one of any of such structural elements.

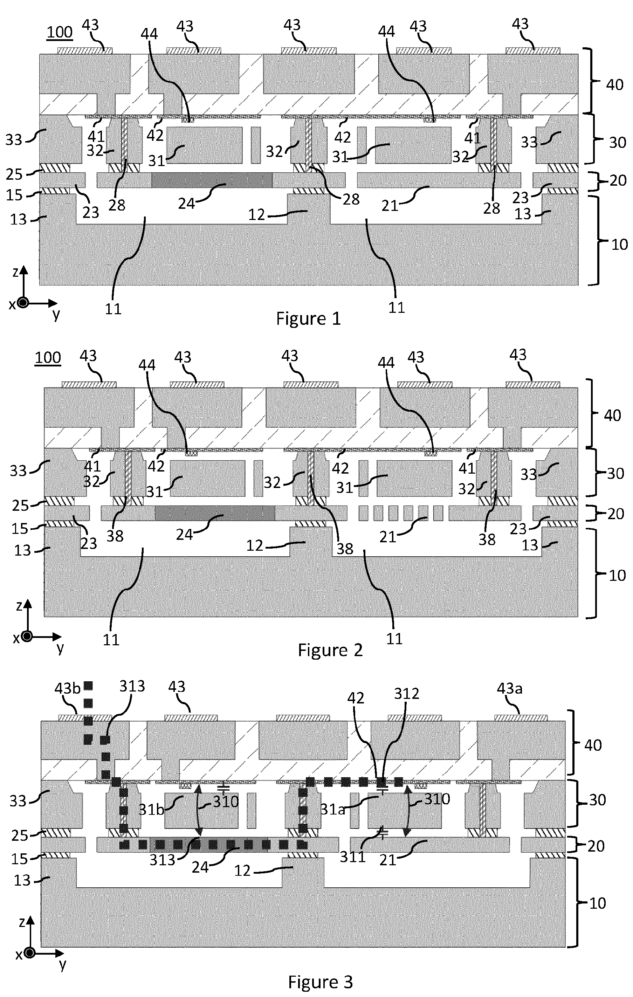

Figure 1 illustrates a cross-section of a MEMS device according to a first embodiment.

Starting from the bottom of the MEMS device **100,** first layer is a handle layer **10** made of mono-Si. The handle layer **10** comprises at least one cavity **11.** In the cavity **11,** there is at least one suspension structure **12** also known as anchor. The at least one cavity **11** is preferably formed as a basin such that it does not reach lateral sides of the bottom layer **10,** so that walls **13** are provided in the handle layer **10** on the outer circumference thereof. The at least one cavity **11** increases distance from the bottom of the cavity **11** towards a first device layer **20** above the handle layer **10.** The increased distance decreases unwanted parasitic capacitance between the handle layer **10** and structural elements in the superimposed first device layer **20.**

Between the handle layer **10** and the first device layer **20,** there is an electrically insulating layer **15.** Majority of the sacrificial electrically insulating layer **15** is removed in the manufacturing process, but as can be seen in the Figure 1, portions of the electrically insulating layer **15** remain between the handle layer **10** and the first device layer **20.** The electrically insulating layer is preferably made of silicon dioxide. The electrically insulating layer **15** facilitates bonding between the handle layer **10** and the first device layer **20,** forms a part of walls of an enclosure in which all functional elements of the MEMS device are enclosed and is also used as sacrificial layer during manufacture, while supporting and protecting structures during manufacturing process before it is removed.

The first device layer **20** made of mono-Si comprises structural elements that are mechanically suspended on the suspension structures **12** provided in the handle layer **10** and/or by suspension structures **32** provided in a second device layer **30** conveying suspension on the cap layer **40.** Structural elements on the first device layer **20** are fixed. Mass of a static electrode can be smaller than what would be needed for a seismic mass. Therefore, thickness of the first device layer **20** may be relatively small, although thick enough to form essentially rigid structural elements that are not acting as springs. Structural elements on the first device layer **10** are advantageously used for example as static electrodes **21** in capacitive electrode pairs that may be used either for sensing or for driving purposes. Another possible use of structural elements on the first device layer **10** is for signal routing. This is illustrated by signal bearing beam **24** that may travel between a seismic element **31** on the second device layer **30** and the cavity **11.** For reducing unwanted capacitance between the seismic element **31** and the signal bearing beam **24,** the signal bearing beam **24** is preferably made narrow in lateral (x-axis) dimension so that overlapping area between the two is small.

The first device layer **20** preferably comprises a frame portion **23** that encircles structural elements of the first device layer **10** and forms part of outer walls of the enclosure that comprises structural elements of the MEMS device.

Because structural elements on the first device layer **20** are only supported to the handle layer **10** and/or via the second device layer **30** to the cap layer **40** by distinct suspension structures **12, 32,** structural elements on the first device layer **20** are less sensitive to stress affecting the MEMS device **100:** deformation of the cap layer **40** or the handle layer **10** due to stress causes less deformation or displacement of structural elements on the first device layer **20** and thus less change in distance occurs between structural elements of the first device layer to structural elements of the second device layer **30** due to mechanical stress affecting the MEMS device **100.**

Above the first device layer **20,** there is a second device layer **30** that comprises seismic elements **31** of the MEMS device **100.** For facilitating seismic movement, seismic elements **31** can be increased by making the second device layer **30** thicker than the first device layer **20.** Preferably, thickness of the second device layer **30** is at least twice the thickness of the first device layer **20.**

Between the first device layer **20** and the second device layer **30,** there is an electrically insulating layer **25.** Majority of the sacrificial electrically insulating layer **25** is removed in the manufacturing process, but as can be seen in the Figure 1, portions of the electrically insulating layer **25** remain between the first device layer **20** and the second device layer **30.** The electrically insulating layer is preferably made of silicon dioxide. The electrically insulating layer **25** facilitates bonding between the first device layer **20** and the second device layer **30,** forms a part of walls of an enclosure in which all functional elements of the MEMS device are enclosed and is also used as sacrificial layer during manufacture, while supporting and protecting structures during manufacturing process before removed.

Polysilicon feedthroughs **28** provide electrical connections over the electrically insulating layer **25** between the first device layer **20** and the second device layer **30,** enabling carrying electrical signals to and from the first device layer **10.**

The second device layer **30** is made of mono-Si and comprises seismic elements that are indirectly, via the first device layer **20,** suspended on the suspension structures **12** provided in the handle layer **10** and/or by rigid suspension structures **32** within the second device layer **30** that are suspended on the cap layer **40.** As known in the art, for enabling movement of the seismic elements **31,** suspension thereof is implemented with springs and/or flexible beams (not shown).

The second device layer **30** preferably comprises a frame portion **33** that encircles structural elements of the second device layer **30** and forms part of outer walls of the enclosure that comprises structural elements of the MEMS device **100.**

Structural parts of the first and second device layers **20, 30** are enclosed in an enclosure between the handle wafer **10** and a cap layer **40** that is bonded on top of the second device layer **30.** Walls **13** of the handle wafer **10,** frame portions **23, 33** of the first and second device layers **20, 30** together with insulator layers **15, 25** form walls of the enclosure.

In the shown example, the cap layer **40** comprises metallized contacts **41** on the bottom face of the cap layer **40** that both mechanically and electrically couple the support structures **32.** Optionally, metallized patterns may also be provided on the bottom face of the cap layer **40** to operate as static electrodes **42.** Metallized contacts **41** and static electrodes **42** are electrically coupled through the cap layer **40** to metallized contact pads **43** on the top side of the cap layer **40.** When no electrical contact is required, support structures may be mechanically bonded to the cap layer **40** by anodic bonding. For maximum stress robustness, only the first device layer **10** should be used for static electrodes **21.** Implementing further static electrodes **42** on the cap layer **40** makes the MEMS device more susceptible to the stress.

Optionally, the cap layer **40** may be provided with one or more bumps **44** that prevent the one or more seismic masses **31** from becoming into direct contact with the static electrodes **42** or other metallized patterns on the bottom face of the cap layer **40.** Bumps **44** are preferably made of electrically insulating material such as SiO₂ or Si₄N₄.

Figure 2 illustrates a cross-section of a MEMS device according to a second embodiment. Majority of the features are similar to that of the first embodiment and are therefore not repeated.

In this embodiment, polysilicon feedthroughs **38** that electrically combine the first and the second device layers **20, 30,** are manufactured in a different phase of the manufacturing process, namely during manufacturing of the second device layer **30,** and extend therefore through the second device layer **30** and the electrically insulating layer **25.**

Other structural difference from the first embodiment is that the static electrode **21** in the first device layer **20** is perforated to enable removal of the sacrificing electrically insulating layer **25** between the seismic mass **31** and the structural element **21.** Perforation reduces capacitance between the static electrode **21** and the seismic mass **31,** because the superimposed area between these two is reduced. However, also this embodiment has improved robustness against stress, because the static electrode **21** is not integrated to the cap layer **40** or the handle layer **10.**

Figure 3 is a simplified illustration that schematically features of the MEMS device that enable main technical benefits achieved. Structural parts of the MEMS device in this illustration corresponds to those of Figures 1 and 2, and some reference numbers have been omitted for clarity.

In this example, both seismic masses **31a, 31b** are configured to move in vertical dimension, as illustrated by the curved arrows **310.** Variable capacitances between the seismic mass **31a** on the right and two static electrodes **21, 42** can be sensed as illustrated with capacitors **311** and **312** while distance between the seismic mass **31a** changes. Electrical signal from the static electrode **21** is provided towards the contact pad **43a.** The double-layer structure is utilized for routing electrical signal from the static electrode **42** all the way via two poly-Si feedthroughs **38** formed in the support structures **32** and via the signal bearing beam **24** to the contact pad **43b.** This signal path is illustrated with the thick dotted line **313.** Because in this example, the signal bearing beam **24** travels under the second seismic mass **31b,** this second seismic mass **31b** is not provided with a static electrode in the first device layer **20.** Instead of implementing a signal path from the static electrode **42** on the cap layer **40,** a like signal path may be provided for the static electrode **21** on the first device layer **20.** As explained above, using a static electrode **42** on the cap wafer makes the device more sensitive to errors caused by stress. For maximizing robustness against stress, sole use of the first device layer for implementing static electrodes such as static electrode **21** is preferred.

It should be understood that this exemplary signal path is by no means limiting the scope but is intended to illustrate the enhancement in signal routing flexibility provided by use of two device layers that greatly facilitates improved freedom of design of device layers of the MEMS device.

Figures 1, 2 and 3 illustrate seismic masses **31, 31a, 31b** that is as such used as the moveable electrode. Such arrangement is of course optional, and the moveable electrode may also be attached to a seismic mass such that movement of the seismic mass is conveyed to a movement of the moveable electrode.

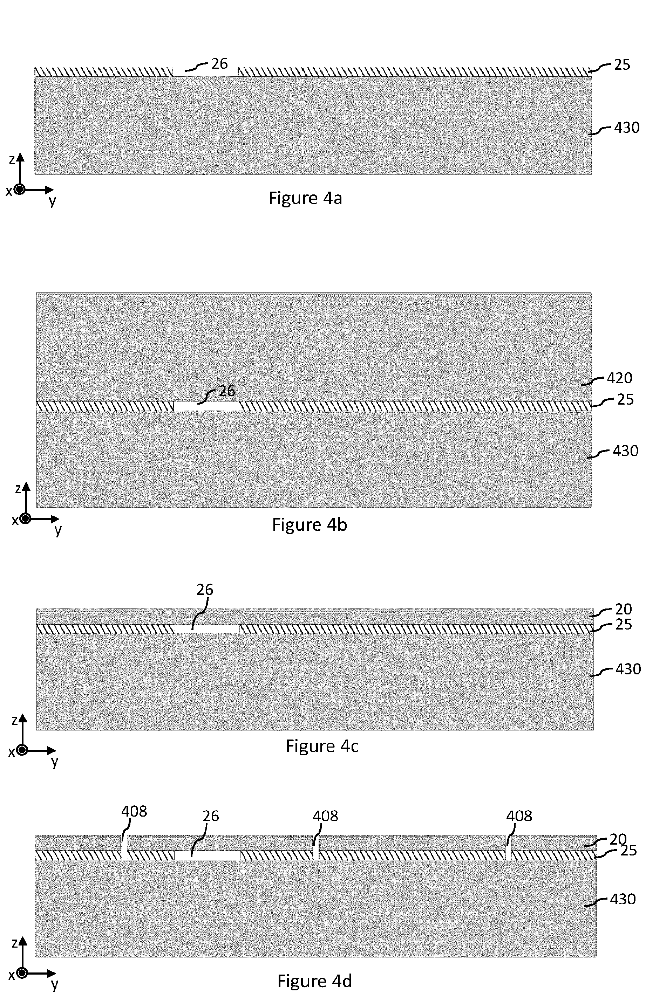

Figures 4a to 4l illustrate a manufacturing process of a MEMS device according to a third embodiment. In the third embodiment, poly-Si feedthroughs 28 that electrically and mechanically connect the first device layer **20** and the second device layer **30,** travel through the first device layer **20.**

Figure 4a shows a second device wafer **430,** which will be eventually become the second device layer. The second device wafer **430** is a mono-Si wafer. An electrically insulating layer **25,** preferably of silicon dioxide is built on one face of the second device wafer **430.** This electrically insulating layer **25** is generated using thermal oxidation. Depending on the MEMS device design, this electrically insulating layer **25** may be patterned by etching. Examples of applicable etching methods are wet etching by buffered hydrofluoric acid (BHF) and reactive ion plasma etching. This optional etching step may be referred to as pre-etching. In this example, pre-etching is used for removing a portion **26** of the electrically insulating layer **25** that would eventually reside between a capacitive electrode pair. Without removing the electrically insulating layer by pre-etching, perforation of a structural layer would be needed for removal of this unwanted portion of the electrically insulating layer **25** at the end of the process. Thus, the pre-etching step helps in increasing capacitance and mass and thus improving sensitivity of capacitive electrode pair.

Figure 4b illustrates next step, in which a first device wafer **420** is fusion bonded on top of the electrically insulating layer **25.** The first device wafer **420** is also a mono-Si wafer.

Since the first device wafer **420** and the second device wafer **430** are both made of mono-Si, actual order of placing these can be freely selected. In this illustration, we have selected the naming based on order of processing the device layers and also reflecting the order of layers starting from the bottom of the finalized MEMS device structure.

Figure 4c illustrates a step in which the first device wafer **420** is thinned. Thinning may be performed for example by grinding, plasma etching or wet chemical etching. Chemical mechanical polishing (CMP) is needed to provide smooth surface and to remove roughness after thinning and residual surface damages from grinding. Although the first device layer **20** still needs several manufacturing steps before it is ready, from this step onwards, the first device wafer **420** is referred to as the first device layer **20.**

Figure 4d illustrates a step that starts generation of poly-Si feedthroughs **28.** Feedthrough holes **408** are generated in the first device layer **20** and further, the electrically insulating layer **25** at the bottom of these feedthrough holes **408** to reveal the second device wafer **430** at the bottom of these feedthrough holes **408.** Preferably, DRIE etching is used for etching the first device layer **20** made of mono-Si, and buried oxide etching is used for removing portions of the electrically insulating layer **25.** As known by a skilled person, buried oxide refers to the insulating oxide layer in the SOI wafer. Suitable etching methods for etching the buried oxide are for example wet etching by BHF and reactive ion plasma etching.

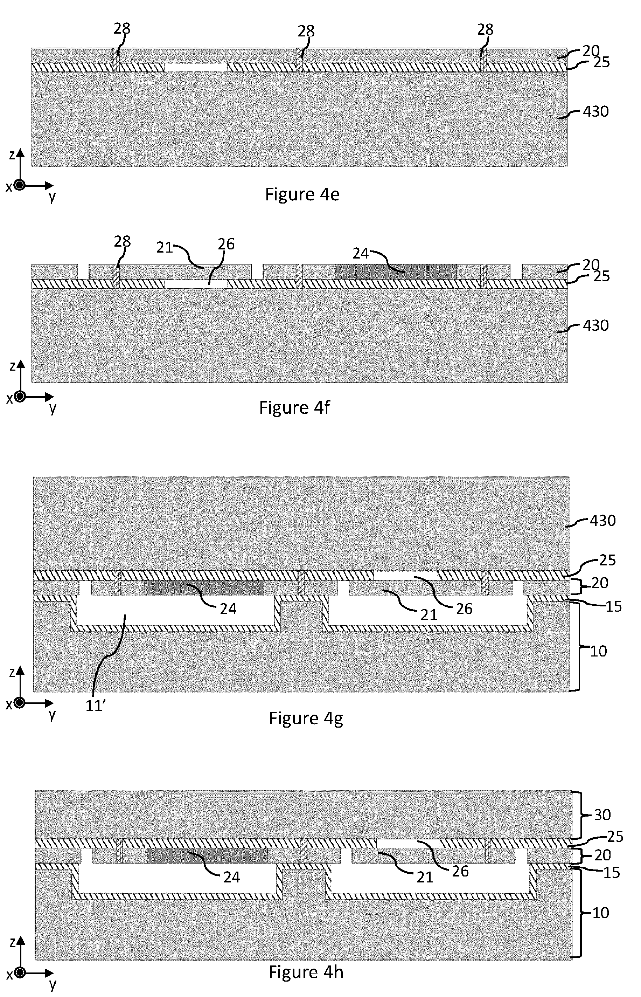

Figure 4e illustrates result of poly-Si deposition. Poly-Si is deposited over the entire upper face of the first device layer **20** until the feedthrough holes **408** are filled with Poly-Si. Then any excess poly-Si is removed from the upper face for example by using grinding and chemical mechanical policing (CMP) so that only the defined poly-Si feedthroughs **28** remain. Also, plasma etching or wet chemical etching can be used. Polysilicon deposition is preferentially made using low-pressure chemical vapor process which deposits polysilicon layer also on the wafer backside, unless backside is masked during the deposition process e.g. with a blank wafer. Polysilicon layer in the wafer back side is not shown as it can be left there or removed using commonly known etching methods.

Figure 4f illustrates patterning of the first device layer 20. The first device layer is preferably patterned using lithography and etching, such as DRIE etching. During patterning, fixed structures such as static electrodes **21** and signal bearing beam **24** are formed in the first device layer **20.**

Figure 4g illustrates a step after fusion bonding the first device layer **20** with the handle layer **10** that comprises at least one oxidized cavity **11'.** For this purpose, the work item has been flipped upside down so that the first device layer **20** is downwards and the second device wafer **430** is on the top.

In the Figure 4h, the second device wafer **430** has been thinned at least approximately into a thickness of the second device layer **30** for example by using grinding or etching. Chemical mechanical polishing (CMP) is used to provide smooth surface and to remove roughness after thinning and residual surface damages from grinding. Because the second device layer **30** comprises seismic masses, which beneficially have a large mass, thickness of the second device layer **30** is preferably at least two times the thickness of the first device layer **20.**

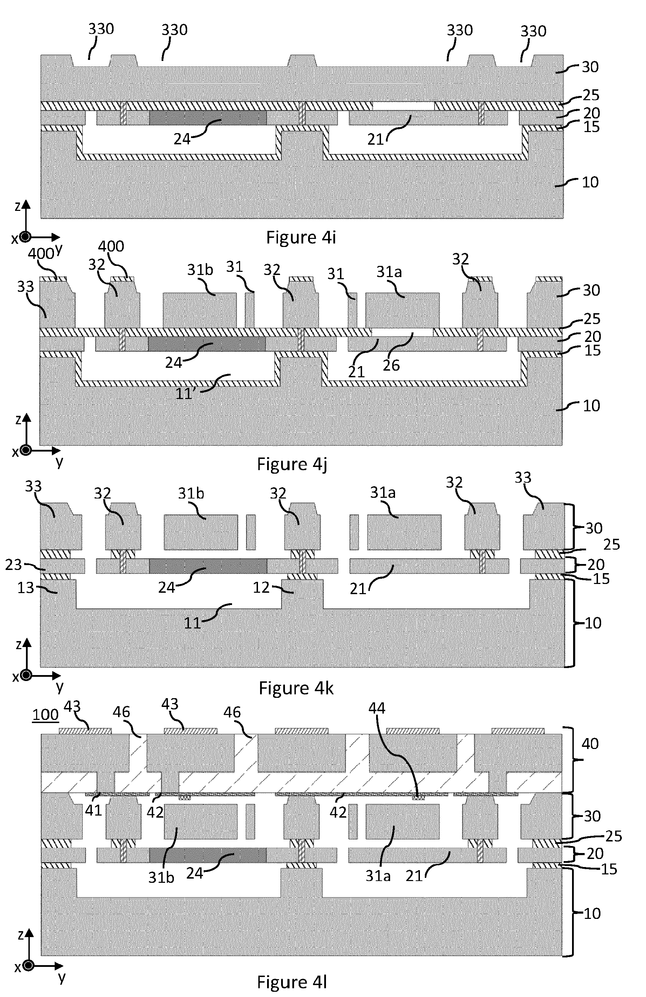

Figure 4i illustrates recessed portions **330** on the upper face of the second device layer **30.** Recessing of the recessed portions **330** can be performed using a LOCal Oxidation of Silicon (LOCOS) process, where SiO₂ is formed in selected areas on the upper face of the second device layer **30** and subsequently the formed SiO₂ is removed by etching to form the recessed portions **330** on the surface. Other alternatives exist, such as etching. One purpose of this recession is to form free space above seismic masses such that they have room for movement in z-axis direction also after a cap layer has been placed on top. Alternative to LOCOS process, recess can be made using silicon wet etching or plasma etching.

Figure 4j illustrates forming of support structures **32** and seismic masses **31a, 31b** in the second device layer **30** by patterning and etching the mono-Si layer of using dry etching such as DRIE. Although not shown, support structures in the second device layer also comprise springs and/or beams that control movement of the seismic masses. During DRIE etching, the portions of the second device layer **30** such as the support structures **32,** the poly-Si feedthroughs **38** and the frame portion **33** that are not to be etched are protected by a masking pattern **400** of e.g. Silicon dioxide (SiO₂).

Figure 4k illustrates results of releasing structural elements in the first **20** and second device layers **30** by removing buried SiO₂. This can be performed using hydrofluoric acid (HF) vapor etching. In controlled HF release, a defined amount of SiO₂ is removed in all directions. The HF release also removes electrically insulating layer from the cavity **11** and a portion of the electrically insulating layer between the handle layer **10** and the first device layer **20** on the suspension structures **12** and on the side walls **13,** between supporting structures **32** and structural elements on the first device layer **20** and between frame portions **23, 33** of the first device layer **20** and the second device layer **10.** Sufficient area of electrically insulating layer **15, 25** remains to maintain contact between the handle layer **10,** the first device layer **20** and the second device layer **30** where needed. Pre-etching performed between the seismic mass **31a** on the right hand side and the underlying static electrode **21,** which have a large lateral area between them for providing a high capacitance, avoids need to perforate the silicon layer in order to remove the electrically insulating layer between these by the HF release process step. On the other hand, pre-etching is not needed below the seismic mass **31b** on the left-hand side, because the signal bearing beam **24** is thin enough in the x-axis direction such that the HF release can therefore remove all electrically insulating layer between the signal bearing beam **24** and the seismic mass **31b.**

Figure 4l illustrates the MEMS device **100** after functional elements have been enclosed in an enclosure by fixing a cap layer **40** on top of the second device layer **30.** In this example, the cap layer **40** comprises glass **46** insulated silicon and metallized contacts **41, 43,** possible static electrodes **42,** and the cap layer **40** is attached using anodic bonding and using anodic bonding and subsequent back-end process. Instead of the glass insulated silicon cap layer, any other suitable type of cap layer can be used in any of the disclosed embodiments. For example, the cap layer may be an Integrated Circuit (IC) wafer with electrodes.

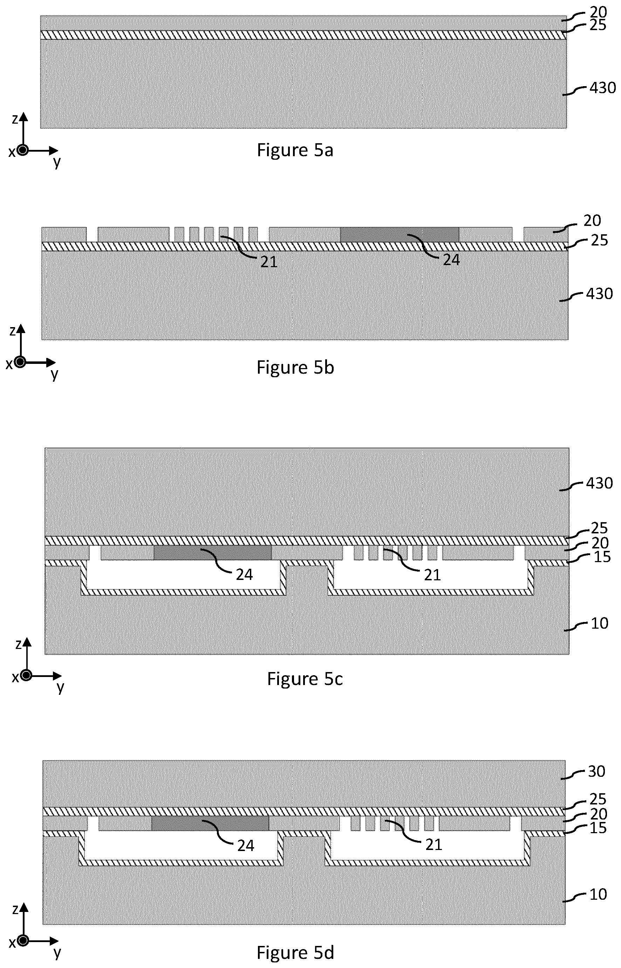

Figures 5a to 5j illustrate a manufacturing process of a MEMS device according to the second embodiment.

Figure 5a illustrates a silicon on insulator (SOI) wafer comprising a second device wafer **430,** an electrically insulating layer **25** and the first device layer **20.** The first device layer **20** may be initially grinded and/or polished from a thicker first device wafer as seen in the figures 4b and 4c, but in this manufacturing process variation, no pre-etching is performed, but the electrically insulating layer **25** fills the entire space between the two mono-Si layers.

Figure 5b illustrates forming structures of the first device layer by dry etching, such as DRIE. The static electrode **21** is perforated. The signal carrying beam **24** is made thin in the x-axis direction as above.

In the figure 5c, the first device layer **20** is turned downwards by flipping the device upside down and fusion bonded to the oxidized handle wafer **10.**

In the figure 5d, the second device wafer **430** has been thinned to form the second device layer **30.** Thinning can be implemented for example by grinding and CMP.

In this alternative, electrical connection between the first device layer **20** and the second device layer **30** is created by manufacturing poly-Si feedthroughs through the second device layer **30.** Other aspects of the process for manufacturing the poly-Si feedthroughs are similar as described above.

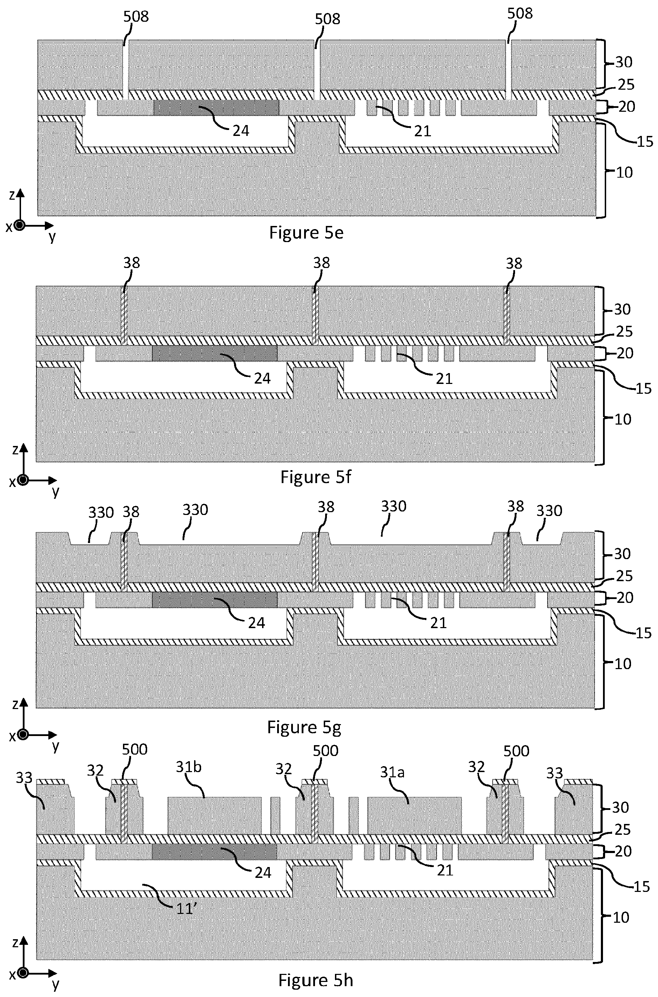

Figures 5e and 5f illustrate generation of Poly-Si feedthroughs in this embodiment.

Figure 5e shows feedthrough holes **508** generated in the second device layer **30** and further, in the electrically insulating layer **25** at the bottom of these feedthrough holes **508** to reveal the first device layer **30** at the bottom of these feedthrough holes **508.** Preferably, a combination of silicon DRIE etching and silicon dioxide plasma etching is used for etching the second device layer **30** made of mono-Si, and buried oxide **25** under the feedthrough holes **508.**

Figure 5f illustrates result of poly-Si deposition. Poly-Si is deposited over the entire upper face of the second device layer **30** until the feedthrough holes **508** are filled with Poly-Si. Then any excess poly-Si is removed from the upper face for example by using grinding and chemical mechanical policing (CMP) so that only the defined poly-Si feedthroughs **38** remain.

Figure 5g illustrates recessed portions **330** on the upper face of the second device layer **30.** Recessing of the recessed portions **330** can be performed for example using a LOCal Oxidation of Silicon (LOCOS) process, where SiO₂ is formed in selected areas on the upper face of the second device layer **30** and subsequently the formed SiO₂ is removed by etching to form the recessed portions **330** on the surface. One purpose of this recession is to form free space above seismic masses such that they have room for movement in z-axis direction also after a cap layer has been placed on top.

Figure 5h illustrates forming of support structures **32** and seismic masses **31a, 31b** in the second device layer **30** by etching the mono-Si layer using dry etching such as DRIE. Although not shown, support structures in the second device layer also comprise springs and/or beams that control movement of the seismic masses. During DRIE etching, the portions of the second device layer such as the support structures **32,** the poly-Si feedthroughs **38** and the frame portion **33** that are not to be etched are protected by a protecting mask pattern **500** like SiO₂.

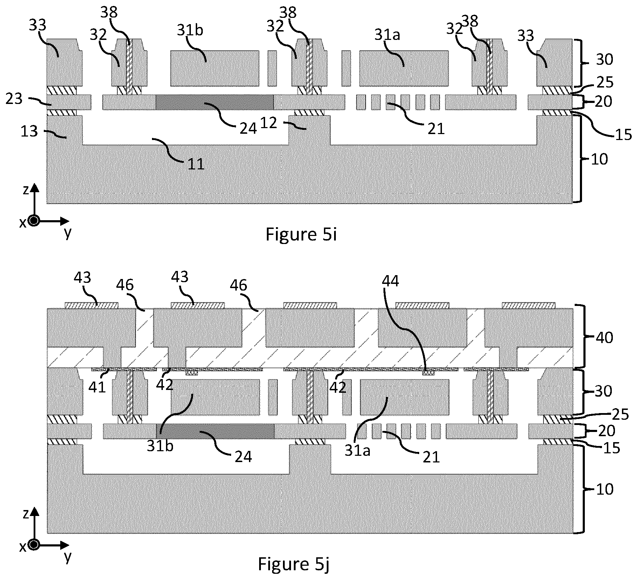

Figure 5i illustrates results of releasing structural elements in the first **20** and second device layers **30** by removing SiO₂. This can be performed using hydrofluoric acid (HF) vapor etching. In controlled HF release, a defined amount of SiO₂ is removed in all directions. The HF release also removes electrically insulating layer from the cavity **11** and a portion of the electrically insulating layer between the handle layer **10** and the first device layer **20** on the suspension structures **12** and on the side walls **13,** between supporting structures **32** and structural elements on the first device layer **20** and between frame portions **23, 33** of the first device layer **20** and the second device layer **10.** Sufficient electrically insulating layer **15, 25** remains to maintain contact between the handle layer **10,** the first device layer **20** and the second device layer **30** where needed. Perforation of the static electrode **21** enables removing all electrically insulating layer material between the seismic mass **31a** and the static electrode **21.**

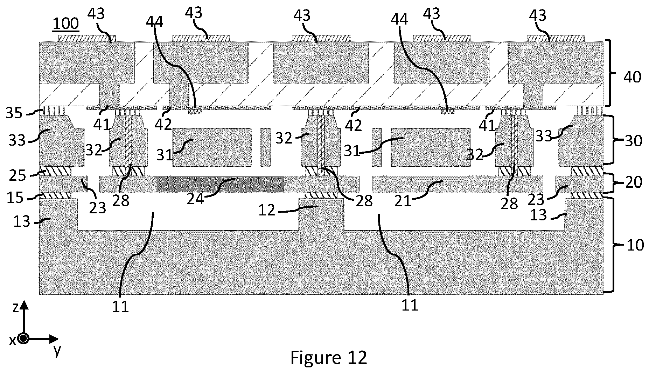

Figure 5j illustrates the MEMS device **100** after functional elements have been enclosed in an enclosure by fixing a cap layer **40** on top of the second device layer **30.** In this example, the cap layer **40** comprises glass **46** insulated silicon and metallized contacts **41, 43,** possible static electrodes **42,** and the cap layer **40** is attached using anodic bonding and subsequent back-end process. Instead of the glass insulated silicon cap layer, any other suitable type of cap layer can be used. Also other wafer bonding than anodic bonding can be used. For example, eutectic bonding using aluminum and germanium can be used. The aluminum and germanium layers are deposited and patterned to cap and structure wafers before bonding. A MEMS device with eutectic bonding is illustrated in the figure 12.

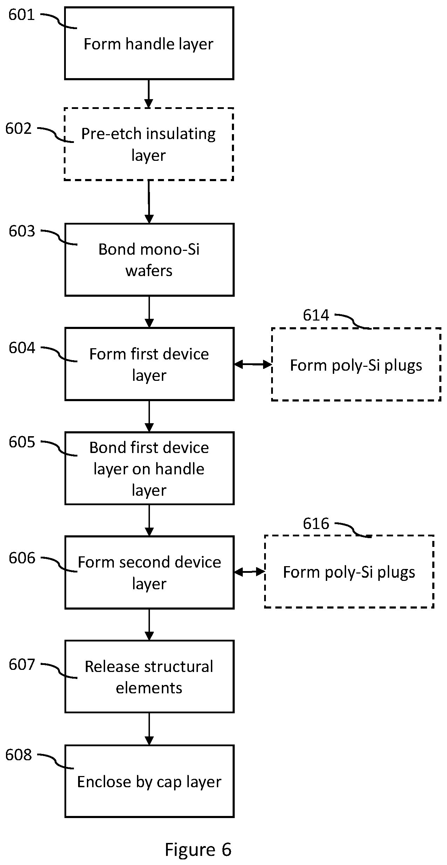

The MEMS device **100** according to the first embodiment can be manufactured by a suitable combination of the manufacturing processes shown in figures 4a to 4i and figures 5a to 5j. While mainly following the process as shown in figures 5a to 5j, the pre-etching step shown in the figure 4a is preferably applied for removing a portion **26** of the electrically insulating layer **25** that will eventually reside between a capacitive electrode pair, thus avoiding the need for perforating large structural elements in the first device layer **20.**Figure 6 illustrates main steps of a manufacturing process according to embodiments of the invention.

In the step **601,** the handle layer **10** is formed out of a mono-Si wafer. Preferably, the handle layer **10** comprises at least one cavity **11'** and the upper face of the handle layer **10** is protected by an electrically insulating layer **15.** The at least one cavity **11'** comprises one or more suspension structures **12** such as anchors. The at least one cavity is basin-like, which means that there are side walls **13** about the at least one cavity **11'.**

In optional step **602,** an electrically insulating layer **25** laid on a first device wafer **420** is pre-etched.

In the step **603** the first device wafer **420** and the second device wafer **430** are fusion bonded to each other, connected by the electrically insulating layer **25.** The first device wafer **420** and the second device wafer **430** are both mono-Si wafers.

In the step **604** structural elements of the first device layer **20** are formed. This forming process includes thinning the first device wafer **420** to a defined thickness of the first device layer **20** and dry etching the mono-Si material of the first device layer **20.** Optionally, steps of forming the first device layer **20** comprise forming poly-Si feedthroughs for electrically connecting the first device layer **20** and the second device wafer **430** as illustrated with step **614.**

In the step **605,** the first device layer is fusion bonded on the handle layer **10.**

In the step **606,** structural elements of the second device layer **30** are formed. This forming process includes thinning the second device wafer **430** to a defined thickness of the second device layer **30** and dry etching the mono-Si material of the second device layer **30.** As an alternative to step **614,** steps of forming the second device layer **30** comprise forming poly-Si feedthroughs for electrically connecting the first device layer **20** and the second device wafer **430** as illustrated with step **616.**

In the step **607,** structural elements of the first device layer **20** and the second device layer **30** are released. Releasing can be performed by HF vapor etching, which also removes insulating material from the cavities **11** in the handle layer. Depending on design and dimensions of the structural elements in the first device layer **20** and the second device layer **30,** amount of removal of insulating material varies.

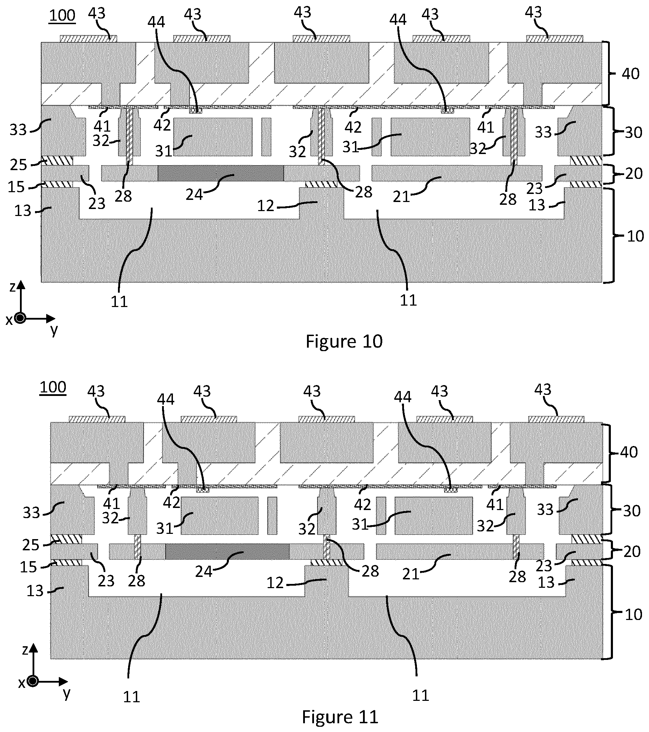

For releasing laterally large areas, the pre-etching step **602** may be utilized. As explained above, perforation of a laterally large structural element facilitates effective removal of insulating material. Example of such processing is shown in figures 5h and 5i, in which a structural element on the first device layer **20** is perforated to facilitate removal portions of the insulating layer between the structural element on the first device layer **20** and a large seismic mass **31** on the second device layer **30.** A further example of using design for controlling releasing of is suspension structures **32** in the figures 10 and 11. When a lateral dimension of a portion of the insulating material is small, i.e. not more than ten times of thickness of the insulating material layer to be removed by HF vapor etching, such portion of the insulating material is removed in its entirety in the step **607.** In the figures 10 and 11, at least one lateral (x and/or y) dimension of the suspension structure **32** is small such that portions of the insulating layer about the poly-Si feedthrough **28** is removed in its entirety so that only the poly-Si feedthrough **28** remains after the HF vapor etching to provide a mechanical coupling and electrical connection between the respective suspension structure **32** and a structural element on the first device layer **20.**

In the step **608,** structural elements of the first device layer **20** and the second device layer **30** are enclosed in an enclosure by affixing a cap layer **40** on top. The cap layer 40 preferably comprises electrical connections.

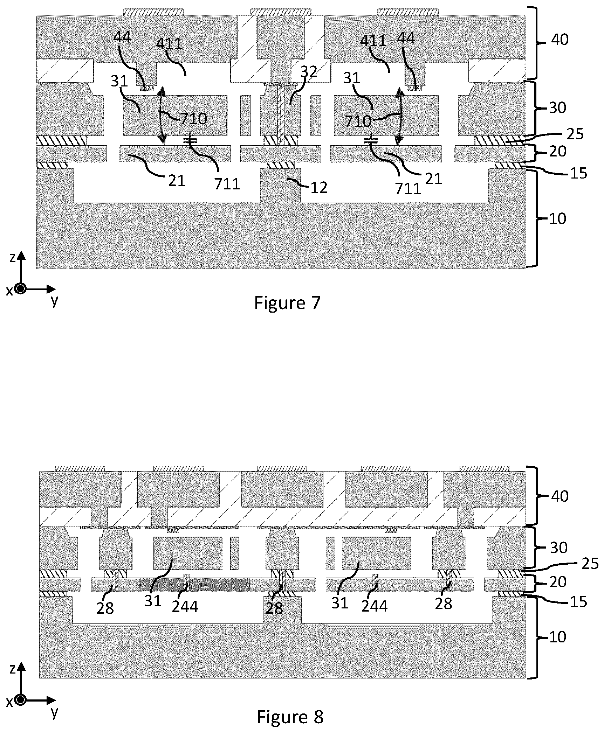

Figure 7 illustrates a cross-section of a MEMS device according to some embodiments. In structure according to this embodiment, capacitive electrode pairs may only be formed between the first device layer **20** and the second device layer **30** as illustrated with capacitors **711.** This exemplary structure shows two capacitive electrode pairs, each having a static electrode **21** in the first device layer **20** and a seismic mass **31** acting as the moveable electrode on the second device layer **30.** Seismic masses **31** are configured to move in the z-axis direction. Capacitance **711** changes in dependence of change of distance between the static electrode **21** and the respective seismic mass **31** acting also as a movable electrode. In some embodiments, a separate movable electrode is attached to a seismic mass **31** such that is moves with the seismic mass in the z-axis direction. At least one cavity **411** is formed in the cap layer **40** to reduce unwanted capacitance between the seismic mass **31** and the cap layer **40.** A bumper **44** may be provided in the cap layer **40** for limiting motion of the seismic mass **31** in the z-axis direction for example during testing and/or very harsh conditions, because excess movement of the seismic mass **31** might cause short-circuit of the measurement capacitance or even breaking of the seismic mass **31** itself and/or suspension structures, such as springs or beams thereof. This type of embodiment with no electrodes on the cap layer **40** enables maximizing stress robustness, since both seismic masses **31** and static electrodes **21** are only attached to the handle wafer **10** and/or to the cap wafer **40** via suspension structures **12, 32.** Furthermore, it is preferred that a seismic mass **31** and the respective static electrode **21** are supported at the same lateral location. As understood by the skilled person, the cap layer **40** may comprise both portions with cavity **411** and portions without cavity, possibly with static electrodes **42.**

Figure 8 illustrates a cross-section of a MEMS device according to some embodiments, with further bumps **244** in the first device layer **20** for limiting movement of one or more inertial masses **31** in the negative z-axis direction.

Bumps **244** may be manufactured from poly-Si by adding further steps in the process of manufacturing poly-Si feedthroughs **28.**

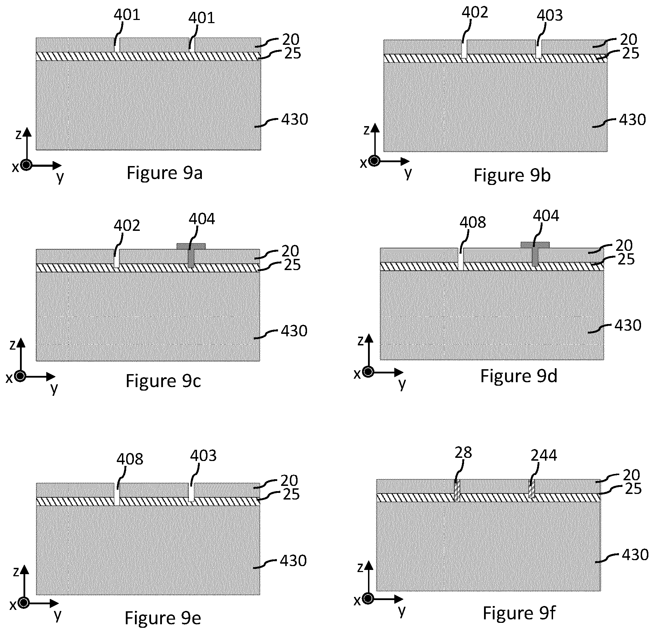

Figures 9a to 9f illustrate an exemplary process for manufacturing poly-Si feedthroughs **28** and bumps **244** as shown in the figure 8.

In the figure 9a, DRIE etching is used for generating holes **401** through the first device layer **20.**

As shown in the figure 9b, the electrically insulating layer **25** is then etched, but just over a part of the thickness of the electrically insulating layer **25,** forming deeper holes **402, 403.** Depth of this partial etching of the electrically insulating layer **25** determines how much the poly-Si feedthroughs will protrude above the upper face of the first device layer **20** in the completed structure.

Deeper holes **403,** which may be referred to as bump holes, at intended locations of the bumps are then covered by a resist pattern **404** as shown in the figure 9c.

As illustrated in the figure 9d, etching of the electrically insulating layer **25** is thereafter continued so that feedthrough holes **408** are formed that go all the way through the first device layer **20** and the electrically insulating layer **25,** reaching the face of the second device wafer **430.**

The resist pattern **404** is then removed as shown in the figure 9e, leaving bump holes **403** and feedthrough holes **408** exposed.

Finally, poly-Si is deposited to fill both bump holes **403** and feedthrough holes **408** as illustrated in the figure 9f, and upper face of the first device layer **20** is planarized by removing any poly-Si residues not within bump holes **403** and feedthrough holes **408.** Upon removal of the electrically insulating layer **25** during the HF release step, bumps **244** are revealed.

Figure 10 illustrates a cross-section of a variation of the first embodiment as shown in the figure 1. In this variation, the which the suspension structures **32** have a laterally smaller area than in the figure 1 such that when the sacrificial electrically insulating layer **25** is removed in the releasing step of the manufacturing process, the insulation material is removed in its entirety between each suspension structure **32,** and the respective structural element in first device layer **20.** The polysilicon feedthrough **28,** here passing through the suspension structure **32** of the second device layer **30,** thus forms the mechanical contact between the suspension structure **32** and the respective structural element of the first device layer **20.**

Figure 11 illustrates a cross-section of a variation of the third embodiment as shown in the figure 4l. The suspension structures **32** have a laterally smaller area than in the figure 4l such that when the sacrificial electrically insulating layer **25** is removed in the releasing step of the manufacturing process, the insulation material is removed in its entirety between each suspension structure **32,** and the respective structural element in the first device layer **20.** The polysilicon feedthrough **28,** here passing through the structural element of the first device layer **20,** thus forms the sole mechanical contact between the suspension structure **32** and the respective structural element of the first device layer **20.**

By using the poly-Si feedthrough 28 as the sole mechanical and electrical coupling between a suspension structure 32 and a structural element of the first device layer 20, suspension structures can be made small, which saves lateral area. This is particularly beneficial for implementing double differential comb structures.

Figure 12 illustrates a cross-section of a further variation of the MEMS device structure according to some embodiments of the invention.

In this variation, a further, electrically conducting, metallic bonding layer **35** is applied between the second device layer **30** and the cap layer **40.** The metallic bonding layer **35** is patterned on the cap layer or on the second device layer or both these layers before the MEMS device is enclosed by the cap layer (step **608).** The metallic bonding layer may be an AlGe layer, or an Au-Au bonding may be used in which metallic bonding layer is preferably patterned both on the cap layer and the second device layer. As understood by a skilled person, the metallic bonding layer **35** can be applied to any one of the above illustrated embodiments.

It is apparent to a person skilled in the art that as technology advanced, the basic idea of the invention can be implemented in various ways. The invention and its embodiments are therefore not restricted to the above examples but are defined by the claims.

## Claims

1. A microelectromechanical system (MEMS) device (100) comprising at least one capacitive electrode pair comprising at least one static electrode (21) and at least one moveable electrode, the device comprising, in order from bottom to top:
- a handle layer (10) comprising at least one cavity (11) and at least one suspension structure (12),
- a first device layer (20),
- a second device layer (30) comprising at least one seismic element (31) moveably suspended above the first device layer, wherein the at least one seismic element (31) acts as the at least one moveable electrode or the at least one seismic element is mechanically coupled to move with the at least one moveable electrode, and
- a cap layer (40),
wherein at least one static electrode (21) is suspended above the cavity (11) by the at least one suspension structure (12) provided in the at least one cavity and/or at least one suspension structure (32) provided in the second device layer, and
wherein the handle layer (10), the first device layer (20), the second device layer (30) and the cap layer (40), a first electrically insulating layer (15) between the handle layer (10) and the first device layer (20) and a second electrically insulating layer (25) between the first device layer (20) and the second device layer (30) are configured to form walls (13, 23, 33) of an enclosure comprising the at least one seismic element (31), the at least one static electrode (21) and the at least one moveable electrode,
**characterized in that** first device layer (20) is mechanically suspended on the suspension structure (12) by the first electrically insulating layer (15), and the first device layer (20) comprises the at least one static electrode (21).

2. The MEMS device (100) according to claim 1, wherein both the first device layer (20) and the second device layer (30) comprise single-crystal silicon (mono-Si).

3. The MEMS device (100) according to claim 1 or 2, wherein thickness of the second device layer (30) at least twice the thickness of the first device layer (20).

4. The MEMS device (100) according to any of claims 1 to 3, wherein the first and second electrically insulating layers (15, 25) comprise silicon dioxide (SiO₂).

5. The MEMS device (100) according to any of claims 1 to 4, wherein there is at least one polycrystalline silicon (poly-Si) feedthrough (28) extending at least between the first device layer (10) and the second device layer (20) for electrically coupling a structural element of the first device layer (20) to a structural element of the second device layer (30) and/or to an electrical connection (41, 42) provided in the cap layer (40).

6. The MEMS device (100) according to claim 5, wherein there is further at least one poly-Si bump (244) extending from a face of a structural element of the first device layer (20) towards an opposing face of a structural element of the second device layer (30).

7. The MEMS device (100) according to claim 5 or 6, wherein electrically insulating material in the second electrically insulating layer (25) has been removed about the at least one poly-Si feedthrough (28) such that the at least poly-Si feedthrough (28) is the only mechanical contact between the respective structural elements of the first device layer (20) and the second device layer (30).

8. The MEMS device (100) according to any of claims 1 to 7, wherein the first device layer (20) further comprises at least one signal bearing beam (24) configured to provide electrical connection.

9. The MEMS device (100) according to any of claims 1 to 8, further comprising a metallic bonding layer (35) between the second device layer (30) and the cap layer (40).

10. A process for manufacturing a MEMS device (100) according to any one of claims 1 to 9, the process comprising:
- forming (601) the handle layer (10) out of a mono-Si handle wafer, the forming of the handle layer comprising forming at least one cavity (11) and simultaneously forming the at least one suspension structure (12) on a first face of the handle layer, and covering the first face of the handle layer with a first electrically insulating layer (15);
- forming a second electrically insulating layer (25) on a first mono-Si wafer (430);
- fusion bonding (603) a second mono-Si wafer (420) on the second electrically insulating layer (25);
- forming (604) the first device layer (20) out of the second mono-Si wafer (420), the forming the first device layer comprising thinning the second mono-Si wafer (420) into a first thickness and forming a plurality of first trenches (408) extending through the first device layer (20) by means of dry etching, wherein the first device layer (20) comprises at least one static electrode (21);
- fusion bonding (605) the first device layer (20) on the first electrically insulating layer (15) on the first face of the handle layer (10);
- forming (606) the second device layer (30) out of the first mono-Si wafer (430), the forming the second device layer (30) comprising thinning the first mono-Si wafer (430) into a second thickness, forming at least one recessed area (330) in the first mono-Si wafer (430) and dry etching a plurality of second trenches extending through the first mono-Si wafer (430);
- releasing (607) structural elements (21, 24, 31, 32) of the first and second device layers (20, 30) by removing exposed portions of the first and second electrically insulating layers (15, 25) over thickness of the first and second electrically insulating layers by hydrofluoric acid (HF) vapor etching, wherein the first electrically insulating layer (15) remains between the first device layer (20) and the suspension structure (12) to maintain mechanical support of the first device layer (20) on the suspension structure (12); and
- enclosing (608) structural elements within the enclosure by bonding the cap layer (40) on top of the second device layer (30).

11. The process according to claim 10, wherein the process comprises, before the fusion bonding (603) the second mono-Si wafer (420) on the second electrically insulating layer (25), pre-etching (602) the second electrically insulating layer (25) for removing at least one portion (26) of the second electrically insulating layer (25).

12. The process according to claim 11, wherein the process further comprises forming (614, 616) at least one polycrystalline silicon (poly-Si) feedthrough (28, 38) extending between the first device layer (20) and the second device layer (30) for implementing at least one electrical connection between the first device layer (20) and the second device layer (30).

13. The process according to claim 12, wherein the at least one poly-Si feedthrough further passes through the first device layer (20), and wherein the generation (614) of the at least one poly-Si feedthrough comprises:
- after thinning the second device wafer (420) and before dry etching the first device layer (20), forming at least one feedthrough hole (408) extending through the first device layer (20) and the second insulator layer (25), depositing poly-Si for filling the at least one feedthrough hole (408) and removing excess poly-Si deposited on the face of first device layer (20) by grinding and/or chemical mechanical polishing (CMP).

14. The process according to claim 13, further comprising generating at least one motion limiting bump (244) in the first device layer.

15. The process according to claim 12, wherein the at least one poly-Si feedthrough (38) further passes through the second device layer (30), and wherein the generation of the at least one poly-Si feedthrough comprises:
- after thinning the first device wafer (430) and before dry etching the second device layer (30), forming at least one feedthrough hole (508) extending through the second device layer (30) and the second electrically insulating layer (25), depositing poly-Si to fill the at least one feedthrough hole (508) and removing excess poly-Si deposited on the face of second device layer by grinding and/or CMP.

16. The process according to any one of claims 12 to 15, wherein, during the step of releasing structural elements, a portion of the second insulating layer (25) in vicinity of the at least one poly-Si feedthrough (28, 38) is removed in its entirety by said HF vapor etching such that the poly-Si feedthrough (28, 38) that electrically connects a structural element (21, 24) of the first device layer (20) to a structural element (32) of the second device layer (30) remains as the sole mechanical coupling between these structural elements.

17. The process according to any of claims 10 to 15, wherein at least one structural element (21) of the first device layer (20) is perforated for enabling HF vapor etching to release of at least one seismic element (31) comprised in the second device layer (30).

18. The process according to any of claims 10 to 17, wherein the process further comprises forming the cap layer (40), wherein the cap layer (40) comprises at least one bump (44) for limiting movement of the at least one seismic element (31).

19. The process according to any of claim 10 to 18, wherein the process further comprises applying a metallic bonding layer between the second device layer (30) and the cap layer (40).

20. The process according to claim 18 or 19, wherein the process further comprises forming at least one cavity (411) on the face of the cap layer (40) that faces the second device layer (30).

## Patentansprüche

1. Mikroelektromechanisches-System-Bauelement (MEMS-Bauelement) (100) umfassend mindestens ein kapazitives Elektrodenpaar, das mindestens eine statische Elektrode (21) und mindestens eine bewegliche Elektrode umfasst, wobei das Bauelement, in Reihenfolge von unten nach oben, umfasst:
- eine Trägerschicht (10), die mindestens einen Hohlraum (11) und mindestens eine Aufhängungsstruktur (12) umfasst,
- eine erste Bauelementschicht (20),
- eine zweite Bauelementschicht (30), die mindestens ein oberhalb der ersten Bauelementschicht beweglich aufgehängtes seismisches Element (31) umfasst, wobei das mindestens eine seismische Element (31) als die mindestens eine bewegliche Elektrode dient oder das mindestens eine seismische Element mechanisch so gekoppelt ist, dass es sich mit der mindestens einen beweglichen Elektrode bewegt, und
- eine Deckschicht (40),
wobei mindestens eine statische Elektrode (21) durch die mindestens eine Aufhängungsstruktur (12), die im mindestens einen Hohlraum vorgesehen ist, und/oder mindestens eine Aufhängungsstruktur (32), die in der zweiten Bauelementschicht vorgesehen ist, oberhalb des Hohlraums (11) aufgehängt ist, und
wobei die Trägerschicht (10), die erste Bauelementschicht (20), die zweite Bauelementschicht (30) und die Deckschicht (40), eine erste elektrisch isolierende Schicht (15) zwischen der Trägerschicht (10) und der ersten Bauelementschicht (20) und eine zweite elektrisch isolierende Schicht (25) zwischen der ersten Bauelementschicht (20) und der zweiten Bauelementschicht (30) dazu ausgelegt sind, Wände (13, 23, 33) einer Umschließung auszubilden, die das mindestens eine seismische Element (31), die mindestens eine statische Elektrode (21) und die mindestens eine bewegliche Elektrode umfasst,
**gekennzeichnet dadurch, dass** die erste Bauelementschicht (20) durch die erste elektrisch isolierende Schicht (15) mechanisch an der Aufhängungsstruktur (12) aufgehängt ist und die erste Bauelementschicht (20) die mindestens eine statische Elektrode (21) umfasst.

2. MEMS-Bauelement (100) nach Anspruch 1, wobei die erste Bauelementschicht (20) und die zweite Bauelementschicht (30) jeweils monokristallines Silicium (mono-Si) umfassen.

3. MEMS-Bauelement (100) nach Anspruch 1 oder 2, wobei die Dicke der zweiten Bauelementschicht (30) mindestens doppelt so groß ist wie die Dicke der ersten Bauelementschicht (20).

4. MEMS-Bauelement (100) nach einem der Ansprüche 1 bis 3, wobei die erste und die zweite elektrisch isolierende Schicht (15, 25) Siliciumdioxid (SiO₂) umfassen.

5. MEMS-Bauelement (100) nach einem der Ansprüche 1 bis 4, wobei es mindestens eine Durchkontaktierung (28) aus polykristallinem Silicium (poly-Si) gibt, die sich mindestens zwischen der ersten Bauelementschicht (10) und der zweiten Bauelementschicht (20) erstreckt, um ein Strukturelement der ersten Bauelementschicht (20) mit einem Strukturelement der zweiten Bauelementschicht (30) und/oder mit einem in der Deckschicht (40) vorgesehenen elektrischen Anschluss (41, 42) elektrisch zu koppeln.

6. MEMS-Bauelement (100) nach Anspruch 5, wobei es ferner mindestens einen poly-Si-Vorsprung (244) gibt, der sich von einer Fläche eines Strukturelements der ersten Bauelementschicht (20) hin zu einer gegenüberliegenden Fläche eines Strukturelements der zweiten Bauelementschicht (30) erstreckt.

7. MEMS-Bauelement (100) nach Anspruch 5 oder 6, wobei das elektrisch isolierende Material in der zweiten elektrisch isolierenden Schicht (25) um die mindestens eine poly-Si-Durchkontaktierung (28) herum entfernt wurde, so dass die mindestens eine poly-Si-Durchkontaktierung (28) der einzige mechanische Kontakt zwischen den jeweiligen Strukturelementen der ersten Bauelementschicht (20) und der zweiten Bauelementschicht (30) ist.

8. MEMS-Bauelement (100) nach einem der Ansprüche 1 bis 7, wobei die erste Bauelementschicht (20) ferner mindestens einen signalführenden Balken (24) umfasst, der zur Bereitstellung einer elektrischen Verbindung ausgelegt ist.

9. MEMS-Bauelement (100) nach einem der Ansprüche 1 bis 8, das ferner eine metallische Bondschicht (35) zwischen der zweiten Bauelementschicht (30) und der Deckschicht (40) umfasst.

10. Verfahren zur Herstellung eines MEMS-Bauelements (100) nach einem der Ansprüche 1 bis 9, wobei das Verfahren umfasst:
- Ausbilden (601) der Trägerschicht (10) aus einem mono-Si-Trägerwafer, wobei das Ausbilden der Trägerschicht umfasst: Ausbilden mindestens eines Hohlraums (11) und gleichzeitiges Ausbilden der mindestens einen Aufhängungsstruktur (12) auf einer ersten Fläche der Trägerschicht, und Bedecken der ersten Fläche der Trägerschicht mit einer ersten elektrisch isolierenden Schicht (15);
- Ausbilden einer zweiten elektrisch isolierenden Schicht (25) auf einem ersten mono-Si-Wafer (430);
- Fusionsbonden (603) eines zweiten mono-Si-Wafers (420) mit der zweiten elektrisch isolierenden Schicht (25);
- Ausbilden (604) der ersten Bauelementschicht (20) aus dem zweiten mono-Si-Wafer (420), wobei das Ausbilden der ersten Bauelementschicht umfasst: Verdünnen des zweiten mono-Si-Wafers (420) zu einer ersten Dicke und Ausbilden von mehreren sich durch die erste Bauelementschicht (20) erstreckenden ersten Gräben (408) mittels Trockenätzen, wobei die erste Bauelementschicht (20) mindestens eine statische Elektrode (21) umfasst;
- Fusionsbonden (605) der ersten Bauelementschicht (20) mit der ersten elektrisch isolierenden Schicht (15) auf der ersten Fläche der Trägerschicht (10);
- Ausbilden (606) der zweiten Bauelementschicht (30) aus dem ersten mono-Si-Wafer (430), wobei das Ausbilden der zweiten Bauelementschicht (30) umfasst: Verdünnen des ersten mono-Si-Wafers (430) zu einer zweiten Dicke, Ausbilden mindestens eines vertieften Bereichs (330) im ersten mono-Si-Wafer (430) und Trockenätzen von mehreren sich durch den ersten mono-Si-Wafer (430) erstreckenden zweiten Gräben;
- Freisetzen (607) von Strukturelementen (21, 24, 31, 32) der ersten und zweiten Bauelementschicht (20, 30) durch Entfernen freiliegender Abschnitte der ersten und zweiten elektrisch isolierenden Schicht (15, 25) über die Dicke der ersten und zweiten elektrisch isolierenden Schicht durch Dampfätzen mit Flusssäure (HF), wobei die erste elektrisch isolierende Schicht (15) zwischen der ersten Bauelementschicht (20) und der Aufhängungsstruktur (12) verbleibt, um die mechanische Abstützung der ersten Bauelementschicht (20) an der Aufhängungsstruktur (12) aufrechtzuerhalten; und
- Umschließen (608) von Strukturelementen innerhalb der Umschließung durch Bonden der Deckschicht (40) oben auf der zweiten Bauelementschicht (30).

11. Verfahren nach Anspruch 10, wobei das Verfahren umfasst: vor dem Fusionsbonden (603) des zweiten mono-Si-Wafers (420) mit der zweiten elektrisch isolierenden Schicht (25), Vorätzen (602) der zweiten elektrisch isolierenden Schicht (25), um mindestens einen Abschnitt (26) der zweiten elektrisch isolierenden Schicht (25) zu entfernen.

12. Verfahren nach Anspruch 11, wobei das Verfahren ferner umfasst: Ausbilden (614, 616) mindestens einer Durchkontaktierung (28, 38) aus polykristallinem Silicium (poly-Si), die sich zwischen der ersten Bauelementschicht (20) und der zweiten Bauelementschicht (30) erstreckt, um mindestens eine elektrische Verbindung zwischen der ersten Bauelementschicht (20) und der zweiten Bauelementschicht (30) zu implementieren.

13. Verfahren nach Anspruch 12, wobei die mindestens eine poly-Si-Durchkontaktierung ferner durch die erste Bauelementschicht (20) verläuft, und wobei das Erzeugen (614) der mindestens einen poly-Si-Durchkontaktierung umfasst:
- nach dem Verdünnen des zweiten Bauelementwafers (420) und vor dem Trockenätzen der ersten Bauelementschicht (20), Ausbilden mindestens eines Durchkontaktierungslochs (408), das sich durch die erste Bauelementschicht (20) und die zweite isolierende Schicht (25) erstreckt, Abscheiden von poly-Si zum Füllen des mindestens einen Durchkontaktierungslochs (408) und Entfernen von überschüssigem auf die Fläche der ersten Bauelementschicht (20) abgeschiedenem poly-Si durch Schleifen und/oder chemomechanisches Polieren (CMP).

14. Verfahren nach Anspruch 13, ferner umfassend: Erzeugen mindestens eines bewegungsbegrenzenden Vorsprungs (244) in der ersten Bauelementschicht.

15. Verfahren nach Anspruch 12, wobei die mindestens eine poly-Si-Durchkontaktierung (38) ferner durch die zweite Bauelementschicht (30) verläuft, und wobei das Erzeugen der mindestens einen poly-Si-Durchkontaktierung umfasst:
- nach dem Verdünnen des ersten Bauelementwafers (430) und vor dem Trockenätzen der zweiten Bauelementschicht (30), Ausbilden mindestens eines Durchkontaktierungslochs (508), das sich durch die zweite Bauelementschicht (30) und die zweite elektrisch isolierende Schicht (25) erstreckt, Abscheiden von poly-Si zum Füllen des mindestens einen Durchkontaktierungslochs (508) und Entfernen von überschüssigem auf die Fläche der zweiten Bauelementschicht abgeschiedenem poly-Si durch Schleifen und/oder CMP.

16. Verfahren nach einem der Ansprüche 12 bis 15, wobei während des Schritts der Freisetzung von Strukturelementen ein Abschnitt der zweiten isolierenden Schicht (25) in der Nähe der mindestens einen poly-Si-Durchkontaktierung (28, 38) durch das HF-Dampfätzen vollständig entfernt wird, so dass die poly-Si-Durchkontaktierung (28, 38), die ein Strukturelement (21, 24) der ersten Bauelementschicht (20) mit einem Strukturelement (32) der zweiten Bauelementschicht (30) elektrisch verbindet, als die einzige mechanische Kopplung zwischen diesen Strukturelementen verbleibt.

17. Verfahren nach einem der Ansprüche 10 bis 15, wobei mindestens ein Strukturelement (21) der ersten Bauelementschicht (20) perforiert ist, um sicherzustellen, dass das HF-Dampfätzen mindestens ein in der zweiten Bauelementschicht (30) enthaltenes seismisches Element (31) freisetzt.

18. Verfahren nach einem der Ansprüche 10 bis 17, wobei das Verfahren ferner umfasst: Ausbilden der Deckschicht (40), wobei die Deckschicht (40) mindestens einen Vorsprung (44) zum Begrenzen der Bewegung des mindestens einen seismischen Elements (31) umfasst.

19. Verfahren nach einem der Ansprüche 10 bis 18, wobei das Verfahren ferner umfasst: Aufbringen einer metallischen Bondschicht zwischen der zweiten Bauelementschicht (30) und der Deckschicht (40).

20. Verfahren nach Anspruch 18 oder 19, wobei das Verfahren ferner umfasst: Ausbilden mindestens eines Hohlraums (411) auf der Fläche der Deckschicht (40), die der zweiten Bauelementschicht (30) gegenüberliegt.

## Revendications

1. Dispositif de système microélectromécanique (MEMS) (100) comprenant au moins une paire d'électrodes capacitives comprenant au moins une électrode statique (21) et au moins une électrode mobile, le dispositif comprenant, dans l'ordre du bas en haut :
- une couche support (10) comprenant au moins une cavité (11) et au moins une structure de suspension (12),
- une première couche de dispositif (20),
- une deuxième couche de dispositif (30) comprenant au moins un élément sismique (31) suspendu de manière mobile au-dessus de la première couche de dispositif, ledit au moins un élément sismique (31) faisant office de ladite au moins une électrode mobile, ou ledit au moins un élément sismique étant couplé mécaniquement de manière à se déplacer avec ladite au moins une électrode mobile, et
- une couche de couverture (40),
dans lequel au moins une électrode statique (21) est suspendue au-dessus de la cavité (11) par ladite au moins une structure de suspension (12) prévue dans ladite au moins une cavité et/ou par au moins une structure de suspension (32) prévue dans la deuxième couche de dispositif, et
dans lequel la couche support (10), la première couche de dispositif (20), la deuxième couche de dispositif (30) et la couche de couverture (40), une première couche isolante électrique (15) entre la couche support (10) et la première couche de dispositif (20) et une deuxième couche isolante électrique (25) entre la première couche de dispositif (20) et la deuxième couche de dispositif (30) sont configurées pour former des parois (13, 23, 33) d'une enceinte comprenant ledit au moins un élément sismique (31), ladite au moins une électrode statique (21) et ladite au moins une électrode mobile,
**caractérisé en ce que** la première couche de dispositif (20) est suspendue mécaniquement sur la structure de suspension (12) par la première couche isolante électrique (15), et la première couche de dispositif (20) comprend au moins une électrode statique (21).

2. Dispositif MEMS (100) selon la revendication 1, dans lequel tant la première couche de dispositif (20) que la deuxième couche de dispositif (30) comprennent du silicium monocristallin (mono-Si).

3. Dispositif MEMS (100) selon la revendication 1 ou 2, dans lequel l'épaisseur de la deuxième couche de dispositif (30) est au moins égale au double de l'épaisseur de la première couche de dispositif (20).

4. Dispositif MEMS (100) selon l'une des revendications 1 à 3, dans lequel les première et deuxième couches isolantes électriques (15, 25) comprennent du dioxyde de silicium (SiO₂).

5. Dispositif MEMS (100) selon l'une des revendications 1 à 4, dans lequel il y a au moins une traversée (28) de silicium polycristallin (poly-Si) s'étendant au moins entre la première couche de dispositif (10) et la deuxième couche de dispositif (20) afin de coupler électriquement un élément de structure de la première couche de dispositif (20) à un élément de structure de la deuxième couche de dispositif (30) et/ou à une connexion électrique (41, 42) prévue dans la couche de couverture (40).

6. Dispositif MEMS (100) selon la revendication 5, dans lequel il y a également au moins une saillie poly-Si (244) s'étendant d'une face d'un élément de structure de la première couche de dispositif (20) vers une face opposée d'un élément de structure de la deuxième couche de dispositif (30).

7. Dispositif MEMS (100) selon la revendication 5 ou 6, dans lequel le matériau isolant électrique dans la deuxième couche isolante électrique (25) a été éliminé autour de ladite au moins une traversée poly-Si (28) de telle sorte que ladite au moins une traversée poly-Si (28) est le seul contact mécanique entre les éléments de structure respectifs de la première couche de dispositif (20) et de la deuxième couche de dispositif (30).

8. Dispositif MEMS (100) selon l'une des revendications 1 à 7, dans lequel la première couche de dispositif (20) comprend également au moins une poutre conductrice de signal (24) configurée pour fournir une connexion électrique.

9. Dispositif MEMS (100) selon l'une des revendications 1 à 8, comprenant également une couche de liaison métallique (35) entre la deuxième couche de dispositif (30) et la couche de couverture (40).

10. Procédé de fabrication d'un dispositif MEMS (100) selon l'une des revendications 1 à 9, le procédé comprenant les étapes consistant à :
- former (601) une couche support (10) à partir d'une tranche support mono-Si, la formation de la couche support comprenant les étapes consistant à former au moins une cavité (11) et simultanément former au moins une structure de suspension (12) sur une première face de la couche support, et recouvrir la première face de la couche support d'une première couche isolante électrique (15);
- former une deuxième couche isolante électrique (25) sur une première tranche mono-Si (430);
- réaliser un bonding par fusion (603) d'une deuxième tranche mono-Si (420) avec une deuxième couche isolante électrique (25);
- former (604) la première couche de dispositif (20) à partir de la deuxième tranche mono-Si (420), la formation de la première couche de dispositif comprenant les étapes consistant à amincir la deuxième tranche mono-Si (420) jusqu'à une première épaisseur et former plusieurs premières tranchées (408) s'étendant à travers la première couche de dispositif (20) moyennant gravure à sec, la première couche de dispositif (20) comprenant au moins une électrode statique (21);
- réaliser un bonding par fusion (605) de la première couche de dispositif (20) avec la première couche isolante électrique (15) sur la première face de la couche support (10);
- former (606) la deuxième couche de dispositif (30) à partir de la première tranche mono-Si (430), la formation de la deuxième couche de dispositif (30) comprenant les étapes consistant à amincir la première tranche mono-Si (430) jusqu'à une deuxième épaisseur, former au moins une zone de renfoncement (330) dans la première tranche mono-Si (430) et graver à sec plusieurs deuxièmes tranchées s'étendant à travers la première tranche mono-Si (430);
- libérer (607) des éléments de structure (21, 24, 31, 32) des première et deuxième couches de dispositif (20, 30) en éliminant des parties exposées des première et deuxième couches isolantes électriques (15, 25) sur l'épaisseur des première et deuxième couches isolantes électriques par gravure à l'acide fluorhydrique (HF) en phase vapeur, ladite première couche isolante électrique (15) demeurant entre la première couche de dispositif (20) et la structure de suspension (12) afin d'assurer le support mécanique de la première couche de dispositif (20) sur la structure de suspension (12); et
- enfermer (608) des éléments de structure dans l'enceinte par bonding de la couche de couverture (40) sur la deuxième couche de dispositif (30).

11. Procédé selon la revendication 10, dans lequel le procédé comprend l'étape consistant à, avant le bonding par fusion (603) de la deuxième tranche mono-Si (420) avec la deuxième couche isolante électrique (25), réaliser une pré-gravure (602) de la deuxième couche isolante électrique (25) afin d'éliminer au moins une partie (26) de la deuxième couche isolante électrique (25).

12. Procédé selon la revendication 11, dans lequel le procédé comprend également l'étape consistant à former (614, 616) au moins une traversée (28, 38) de silicium polycristallin (poly-Si) s'étendant entre la première couche de dispositif (20) et la deuxième couche de dispositif (30) afin de réaliser au moins une connexion électrique entre la première couche de dispositif (20) et la deuxième couche de dispositif (30).

13. Procédé selon la revendication 12, dans lequel ladite au moins une traversée poly-Si passe également à travers la première couche de dispositif (20), et dans lequel la génération (614) de ladite au moins une traversée poly-Si comprend les étapes consistant à :
- après l'amincissement de la deuxième tranche de dispositif (420) et avant la gravure à sec de la première couche de dispositif (20), former au moins un trou de traversée (408) s'étendant à travers la première couche de dispositif (20) et la deuxième couche isolante électrique (25), déposer du poly-Si pour remplir ledit au moins un trou de traversée (408) et retirer le poly-Si excédentaire déposé sur la face de la première couche de dispositif (20) par meulage et/ou polissage chimico-mécanique (CMP).

14. Procédé selon la revendication 13, comprenant également l'étape consistant à générer au moins une butée de limitation de mouvement (244) dans la première couche de dispositif.

15. Procédé selon la revendication 12, dans lequel ladite au moins une traversée poly-Si (38) passe également à travers la deuxième couche de dispositif (30), et dans lequel la génération de ladite au moins une traversée poly-Si comprend les étapes consistant à :
- après l'amincissement de la première tranche de dispositif (430) et avant la gravure à sec de la deuxième couche de dispositif (30), former au moins un trou de traversée (508) s'étendant à travers la première couche de dispositif (30) et la deuxième couche isolante électrique (25), déposer du poly-Si pour remplir ledit au moins un trou de traversée (508) et retirer le poly-Si excédentaire déposé sur la face de la deuxième couche de dispositif par meulage et/ou CMP.

16. Procédé selon l'une des revendications 12 à 15, dans lequel, pendant l'étape consistant à libérer des éléments de structure, une partie de la deuxième couche isolante électrique (25) à proximité de ladite au moins une traversée poly-Si (28, 38) est retirée entièrement par ladite gravure HF en phase vapeur de telle sorte que la traversée poly-Si (28, 38) qui couple électriquement un élément de structure (21, 24) de la première couche de dispositif (20) à un élément de structure (32) de la deuxième couche de dispositif (30), demeure en tant que seul couplage mécanique entre lesdits éléments de structure.

17. Procédé selon l'une des revendications 10 à 15, dans lequel au moins un élément de structure (21) de la première couche de dispositif (20) est perforé pour permettre à la gravure HF en phase vapeur de libérer au moins un élément sismique (31) compris dans la deuxième couche de dispositif (30).

18. Procédé selon l'une des revendications 10 à 17, dans lequel le procédé comprend également l'étape consistant à former la couche de couverture (40), ladite couche de couverture (40) comprenant au moins une saillie de butée (44) pour la limitation de mouvement dudit au moins un élément sismique (31).

19. Procédé selon l'une des revendications 10 à 18, dans lequel le procédé comprend également l'étape consistant à appliquer une couche de liaison métallique entre la deuxième couche de dispositif (30) et la couche de couverture (40).

20. Procédé selon la revendication 18 ou 19, dans lequel le procédé comprend également l'étape consistant à former au moins une cavité (411) sur la face de la couche de couverture (40) qui est opposée à la deuxième couche de dispositif (30).
